# EUROPÄISCHE PATENTANMELDUNG

(11) **EP 2 688 209 A1**
(43) Veröffentlichungstag der Anmeldung: **22.01.2014**
(21) Anmeldenummer: 12176523.4
(22) Anmeldetag: 16.07.2012
(51) Int. Cl.: H03K 17/64, H03K 17/66, H01F 7/18, H01H 47/32

(54) **Treiberschaltungen und Steuerungen für eine Treiberschaltung**

(71) Anmelder: Siemens Aktiengesellschaft, 80333 München (DE)
(72) Erfinder: Seja, Marco, 09661 Rossau / OT Seifersbach (DE); Wild, Robert, 09456 Annaberg-Buchholz (DE)

(57) **Zusammenfassung**

Zum präzisen und energieeffizienten Betreiben von kapazitiven und induktiven Lasten (30) wird eine Treiberschaltung (20) mit einem Treiberausgang (27, 28) zum Betreiben einer elektrischen Last (30) bereitgestellt. Die Treiberschaltung (20) umfasst einen Ladezweig (LZ), der einen ersten steuerbaren Halbleiterschalter (Q1) aufweist, und einen Freilaufzweig (FZ), der zu dem Treiberausgang (27, 28) parallel geschaltet ist. Der Freilaufzweig (FZ) umfasst eine Freilaufdiode (D2) und einen zweiten steuerbaren Halbleiterschalter (Q2), der mit der Freilaufdiode (D2) in Serie geschaltet ist. Unter einem ersten Aspekt umfasst die Treiberschaltung (20) einen Entladezweig (EZ), der einen dritten steuerbaren Halbleiterschalter (Q3) aufweist. Unter einem zweiten Aspekt umfasst die Treiberschaltung (20) einen Demagnetisierungszweig (DZ) mit einem steuerbaren und/oder einem nicht steuerbaren Halbleiterschalter (D4), der zu dem Ladezweig (LZ) oder zu dem Freilaufzweig (FZ) parallelgeschaltet ist. Außerdem wird unter jedem der beiden Aspekte je eine Steuerung (29) für eine erfindungsgemäße Treiberschaltung (20) bereitgestellt.

## Beschreibung

Die Erfindung betrifft eine Treiberschaltung mit einem Treiberausgang zum Betreiben einer elektrischen Last, wobei die Treiberschaltung einen Ladezweig, der einen ersten steuerbaren Halbleiterschalter aufweist, und einen Freilaufzweig umfasst, der zu dem Treiberausgang parallel geschaltet ist, wobei der Freilaufzweig eine Freilaufdiode und einen zweiten steuerbaren Halbleiterschalter umfasst, der mit der Freilaufdiode in Serie geschaltet ist.

Außerdem betrifft die Erfindung eine Treiberschaltung mit einem Treiberausgang zum Betreiben einer elektrischen Last, wobei die Treiberschaltung einen Ladezweig, der einen ersten steuerbaren Halbleiterschalter aufweist, und einen Freilaufzweig umfasst, der zu dem Treiberausgang parallel geschaltet ist, wobei der Freilaufzweig eine Freilaufdiode und einen zweiten steuerbaren Halbleiterschalter umfasst, der mit der Freilaufdiode in Serie geschaltet ist.

Des Weiteren betrifft die Erfindung Steuerungen für eine Treiberschaltung.

Die US 5 647 387A beschreibt eine Treiberschaltung zum Betreiben eines Magnetventils. Hierbei versorgt ein erster Feldeffekttransistor eine Spule eines Magnetventils mit einem Strom. Zum Halten des Magnetventils beaufschlagt der erste Feldeffekttransistors das Magnetventil mit einer getasteten Versorgungsspannung. Während der Tastlücken wird ein zweiter Feldeffekttransistor leitend geschaltet, um während der Tastlücken einen Freilaufstrom zuzulassen.

Unter einem ersten Aspekt hat die bekannte Treiberschaltung den Nachteil, dass sie sich nicht für eine zeitnahe Abschaltung einer kapazitiven Last, beispielsweise eines Kabels eignet.

Unter einem zweiten Aspekt hat die bekannte Treiberschaltung auch folgenden Nachteil. Die Treiberschaltung kann für eine zeitnahe Beendigung der Haltewirkung des Freilaufstroms zwar grundsätzlich so angesteuert werden, dass beide Feldeffekttransistoren in einen nichtleitenden Zustand versetzt werden, wodurch sowohl der Haltestrom wie auch der Freilaufstrom unterbrochen werden. Dann würde sich zwischen den Anschlüssen des Magnetventils eine Spannung aufbauen, die von drei Zehnerdioden unschädlich gemacht wird, welche zum Schutz der Feldeffekttransistoren vorgesehen sind. Aufgrund der etwas unübersichtlichen Schaltungsanordnung lassen sich der zeitliche Ablauf und die Verteilung der Verlustenergie eines Löschens des Freilaufstroms schlecht vorhersagen. Außerdem kann bei der bekannten Schaltungsanordnung nicht von vorneherein ausgeschlossen werden, dass die Bulk-Diode des ersten Feldeffekttransistors durch eine zu hohe Energieaufnahme während des Löschvorgangs gefährdet wird. Eine bessere Vorhersagbarkeit des zeitlichen Ablaufs und der Verteilung der Verlustenergie beim Löschen des Freilaufstroms ist erwünscht, um eine Dimensionierung der Bauelemente und/oder eines Wärmehaushalts der Treiberschaltung zu verbessern.

Der Erfindung liegt unter dem ersten Aspekt die Aufgabe zugrunde, eine gattungsgemäße Treiberschaltung bereitzustellen, die sich auch für eine zeitnahe Abschaltung einer kapazitiven Last eignet. Unter dem zweiten Aspekt liegt der Erfindung die Aufgabe zugrunde, eine gattungsgemäße Treiberschaltung bereitzustellen, deren zeitlicher Ablauf und Verteilung der Verlustenergie beim Entmagnetisieren einer induktiven Last besser vorhersagbar ist.

Erfindungsgemäß wird die Aufgabe unter dem ersten Aspekt dadurch gelöst, dass eine Treiberschaltung mit einem Treiberausgang zum Betreiben einer elektrischen Last bereitgestellt wird, wobei die Treiberschaltung einen Ladezweig, der einen ersten steuerbaren Halbleiterschalter aufweist, und einen Freilaufzweig umfasst, der zu dem Treiberausgang parallel geschaltet ist, wobei der Freilaufzweig eine Freilaufdiode und einen zweiten steuerbaren Halbleiterschalter umfasst, der mit der Freilaufdiode in Serie geschaltet ist. Die Treiberschaltung umfasst einen Entladezweig, der einen dritten steuerbaren Halbleiterschalter aufweist. Durch diese Maßnahmen ist es mit derselben Treiberschaltung nicht nur möglich, induktive Lasten mit einem abgesenkten Haltestrom zu betreiben, sondern auch kapazitive Lasten zeitnah zu entladen. So ist auch bei einem kapazitiv belasteten Aktor (einschließlich evtl. Rückwirkung eines mechanischen Federsystems) eine sehr geringe Ansprechzeit erreichbar.

Es ist zweckmäßig, wenn der Entladezweig zu dem Freilaufzweig parallel geschaltet ist.

Unter dem zweiten Aspekt wird die Aufgabe dadurch gelöst, dass eine Treiberschaltung mit einem Treiberausgang zum Betreiben einer elektrischen Last bereitgestellt wird, wobei die Treiberschaltung einen Ladezweig, der einen ersten steuerbaren Halbleiterschalter aufweist, und einen Freilaufzweig umfasst, der zu dem Treiberausgang parallel geschaltet ist, wobei der Freilaufzweig eine Freilaufdiode und einen zweiten steuerbaren Halbleiterschalter umfasst, der mit der Freilaufdiode in Serie geschaltet ist. Die Treiberschaltung umfasst einen Demagnetisierungszweig mit einem steuerbaren oder einem nicht steuerbaren Halbleiterschalter, der zu dem Ladezweig oder zu dem Freilaufzweig parallelgeschaltet ist. Durch diese Maßnahmen ist eine zeitnahe Löschung eines Stromes möglich, der durch eine induktive Last fließt. So ist auch bei einem induktiv belasteten Aktor (einschließlich evtl. Rückwirkung eines mechanischen Massesystems) eine sehr geringe Ansprechzeit erreichbar.

In Bezug auf die Steuerung wird die Erfindung unter dem ersten Aspekt dadurch gelöst, dass die Steuerung dazu vorbereitet ist, die Treiberschaltung bedarfsabhängig in jedem der folgenden Betriebszustände zu betreiben:
- einem Ladebetriebszustand und/oder einem Haltebetriebszustand, in welchem ein Ladezweig der Treiberschaltung leitend geschaltet ist, während ein Entladezweig der Treiberschaltung nichtleitend geschaltet ist;
- einem Freilaufbetriebszustand, in welchem ein Freilaufzweig der Treiberschaltung leitend geschaltet ist, während der Ladezweig nichtleitend geschaltet ist;
- einem Entladebetriebszustand, in welchem der Entladezweig leitend geschaltet ist, während der Ladezweig und der
- Freilaufzweig nichtleitend geschaltet sind.

Hierdurch kann eine Last schneller in einen aktiven oder inaktiven Betriebszustand versetzt werden und ein Energieverbrauch durch Leckströme vermieden werden.

In Bezug auf die Steuerung wird die Erfindung unter dem zweiten Aspekt dadurch gelöst, dass die Steuerung dazu vorbereitet ist, die Treiberschaltung bedarfsabhängig in jedem der folgenden Betriebszustände zu betreiben:
- einem Ladebetriebszustand und/oder einem Haltebetriebszustand, in welchem ein Ladezweig der Treiberschaltung leitend geschaltet ist, während ein Demagnetisierungszweig der Treiberschaltung nichtleitend geschaltet ist;
- einem Freilaufbetriebszustand, in welchem ein Freilaufzweig der Treiberschaltung leitend geschaltet ist, während der Ladezweig nichtleitend geschaltet ist;
- einem Demagnetisierungsbetriebszustand, in welchem ein Demagnetisierungszweig leitend geschaltet ist, während der Ladezweig und der Freilaufzweig nichtleitend geschaltet sind.

Durch diese Maßnahme kann eine Umwandlung der Energie des Magnetfelds einer induktiven Last auf einen bestimmten Ort der Treiberschaltung konzentriert werden, wo Wärme, die durch Entmagnetisierung entsteht, keine elektrischen oder thermischen Schäden verursachen kann. Ein zuverlässiger Demagnetisierungszweig kann auf kostengünstige Weise realisiert werden, wenn als Halbleiterschalter des Demagnetisierungszweigs eine Suppressordiode oder eine Zenerdiode verwendet wird.

Die Lösungskonzepte beider Aspekte können in einer Treiberschaltung kombiniert werden, indem die Treiberschaltung mit dem Entmagnetisierungszweig (zweiter Aspekt) auch einen Entladezweig (erster Aspekt) umfasst, der einen dritten steuerbaren Halbleiterschalter aufweist. Dann ist es mit derselben Treiberschaltung nicht nur möglich, kapazitive Lasten zeitnah zu entladen, sondern auch induktive Lasten zeitnah zu entladen.

Entsprechendes gilt für eine Steuerung unter dem ersten Aspekt, die auch dazu vorbereitet ist, die Treiberschaltung bedarfsabhängig in einem Entladebetriebszustand zu betreiben, in welchem der Entladezweig leitend geschaltet ist, während der Ladezweig und der Freilaufzweig nichtleitend geschaltet sind. Hierdurch ist zeitnahes Entladen sowohl für induktive als auch für kapazitive Lasten möglich.

Unabhängig davon ist es von Vorteil, wenn die Steuerung dazu vorbereitet ist, die Treiberschaltung in einem Tristate-Betriebszustand zu betreiben, in welchem der Ladezweig, der Freilaufzweig, der Entladezweig und der Demagnetisierungszweig nichtleitend geschaltet sind. Hierdurch kann eine Busfähigkeit der Treiberschaltung verbessert werden und in Ruhezeiten (Tristate-Phasen) eine Rückspeisung verhindert werden.

Besonders bevorzugt ist, wenn eine erfindungsgemäße Treiberschaltung eine erfindungsgemäße Steuerung umfasst. Hiermit kann eine Treiberschaltung bereitgestellt werden, deren Steuerung und innere Beschaltung optimal aufeinander abgestimmt sind, so dass die Treiberschaltung aus Nutzersicht eine optimale Zuverlässigkeit und Anwendbarkeit aufweist.

Die Erfindung ist anhand der beigefügten Zeichnungen näher erläutert, in denen zeigen:
- FIG 1: schematisch eine elektrische Schaltung, die eine erfindungsgemäße Treiberschaltung, eine Spannungsquelle und je eine induktive, kapazitive und ohmsche Last umfasst;
- FIG 2: schematisch einen zeitlichen Verlauf einer Ausgangsspannung und eines Ausgangsstroms am Ausgang der Treiberschaltung mit angeschlossener induktiver Last;
- FIG 3: gemessene Verläufe einer Ausgangsspannung und eines Ausgangsstroms am Ausgang einer erfindungsgemäßen Treiberschaltung mit angeschlossener induktiver Last;
- FIG 4: schematisch einen zeitlichen Verlauf einer Ausgangsspannung und eines Ausgangsstroms am Ausgang der Treiberschaltung mit angeschlossener kapazitiver Last.

Die nachfolgend näher geschilderten Ausführungsbeispiele stellen bevorzugte Ausführungsformen der vorliegenden Erfindung dar.

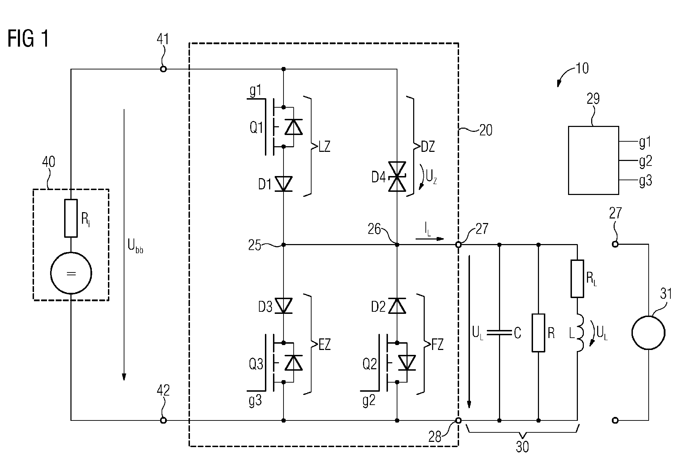

Die in FIG 1 dargestellte Schaltung 10 umfasst eine Treiberschaltung 20, eine Steuerung 29 für die Treiberschaltung 20 und eine elektrische Last 30, die eine induktive Komponente L, eine kapazitive Komponente C sowie ohmsche Komponenten R und R_{L}. Die Treiberschaltung 20 umfasst einen Ladezweig LZ, einen Freilaufzweig FZ, einen Entladezweig EZ und einen Demagnetisierungszweig DZ (der auch als Entmagnetisierungszweig bezeichnet werden kann). Der Ladezweig LZ umfasst einen ersten (steuerbaren) Halbleiterschalter Q1 und eine mit dem ersten Halbleiterschalter Q1 in Serie geschaltete Diode D1. Der Freilaufzweig FZ umfasst einen zweiten (steuerbaren) Halbleiterschalter Q2 und eine mit dem zweiten Halbleiterschalter Q2 in Serie geschaltete Diode D2. Der Entladezweig EZ umfasst einen dritten (steuerbaren) Halbleiterschalter Q3 und eine mit dem dritten Halbleiterschalter Q3 in Serie geschaltete Diode D3. Der Demagnetisierungszweig DZ umfasst als vierten (nichtsteuerbaren) Halbleiterschalter eine Zenerdiode oder eine Suppressordiode D4. Auch im Demagnetisierungszweig kann statt (oder parallel oder in Serie zu) dem nichtsteuerbaren Halbleiter D4 ein steuerbarer Halbleiter vorgesehen sein. Jeder der genannten Halbleiterschalter kann ein IGBT (*Insulated Gate Bipolar Transistor*), ein Feldeffekttransistor, ein Bipolartransistor oder eine andere Art von Halbleiterbauelement sein.

Der Ladezweig LZ und der Entladezweig EZ sind in Serie geschaltet, so dass sie eine Halbbrücke mit einem ersten Abgriff 25 bilden. An dem ersten Abgriff 25 ist der Ladezweig LZ mit dem Entladezweig EZ verbunden. Die andere Seite des Ladezweigs LZ ist mit einer ersten Versorgungsleitung 41 verbunden. Die andere Seite des Entladezweigs EZ ist mit einer zweiten Versorgungsleitung 42 verbunden. Die Dioden D1, D3 im Ladezweig LZ und im Entladezweig EZ sind so angeordnet, dass der Strom im Ladezweig LZ und im Entladezweig EZ nur in Richtung von der ersten Versorgungsleitung 41 zu der zweiten Versorgungsleitung 42 fließen kann.

Der Demagnetisierungszweig DZ ist mit dem Freilaufzweig FZ in Serie geschaltet, so dass die Serienschaltung eine Halbbrücke mit einem zweiten Abgriff 26 bildet. An dem zweiten Abgriff 26 ist der Demagnetisierungszweig DZ mit dem Freilaufzweig FZ verbunden. Die andere Seite des Demagnetisierungszweigs DZ ist mit der ersten Versorgungsleitung 41 verbunden. Die andere Seite des Freilaufzweigs FZ ist mit der zweiten Versorgungsleitung 42 verbunden. Die Diode D2 im Freilaufzweig FZ ist so angeordnet, dass der Strom im Freilaufzweig FZ nur in Richtung von der zweiten Versorgungsleitung 42 zu der ersten Versorgungsleitung 41 fließen kann.

Der zweite Abgriff 25 ist mit dem ersten Abgriff 26 elektrisch verbunden. Der Ladezweig LZ ist zu dem Demagnetisierungszweig DZ parallel geschaltet. Der Entladezweig EZ ist zu dem Freilaufzweig FZ parallel geschaltet. Der Treiberausgang 27, 28, an den die elektrische Last 30 anschließbar ist, ist zu dem Entladezweig EZ und zu dem Freilaufzweig FZ parallel geschaltet.

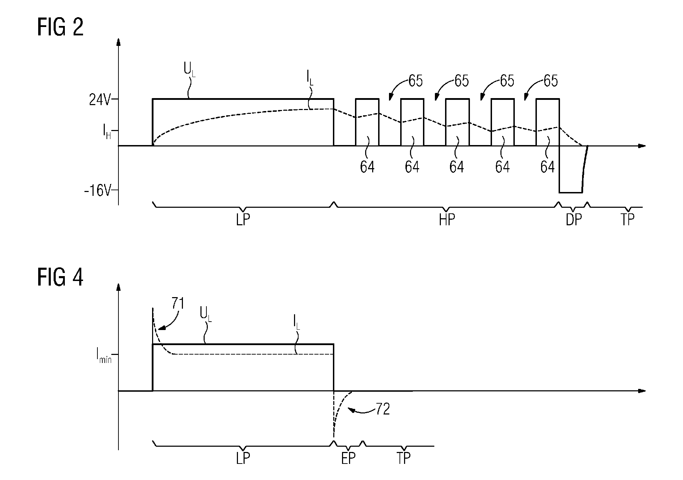

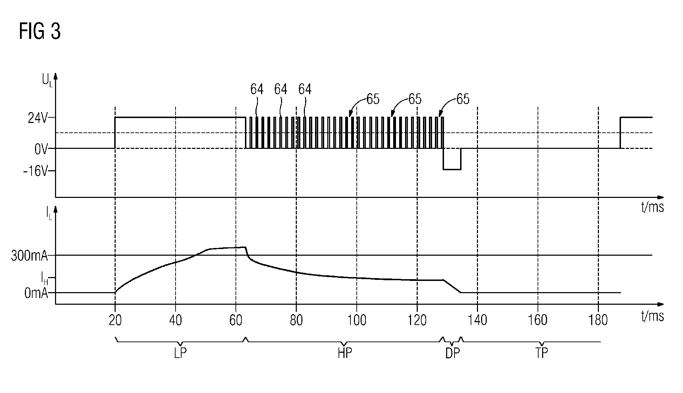

Der in FIG 2 gezeigte zeitliche Verlauf einer Ausgangsspannung U_{L} umfasst eine Ladephase LP, eine Haltephase HP, eine Demagnetisierungsphase DP und eine Tristate-Phase für eine induktive Last 30. Die Abfolge der Phasen LP, HP, DP, TP wird mittels Gatesignalen g1, g2, g3 (siehe FIG 1) gesteuert, welche die Steuerung 29 zum Ansteuern der Gateanschlüsse der Halbleiterschalter Q1, Q2, Q3 erzeugt. Die FIG 3 zeigt für eine gleiche Schaltung 10 gemessene Verläufe der Ausgangsspannung U_{L} und des Ausgangsstroms I_{L} am Ausgang 27, 28 der Treiberschaltung 20.

Die folgende Tabelle gibt einen Überblick über die Schaltzustände der Halbleiterschalter Q1 bis Q4 während der Betriebszustände L, H, F, E, D und T.

| Bezeichnung des Betriebszustands | Q1 | Q2 | Q3 | Q4 |
|---|---|---|---|---|
| (L) Laden (ohne Freilauf) | Ein | Aus | Aus | Aus |
| (H) Halten ('Laden' mit Freilauf) | Ein | Ein | Aus | Aus |
| (F) Freilauf (ohne Laden) | Aus | Ein | X | Aus |
| (E) Entladen (ohne Demagnetisieren) | Aus | Aus | Ein | Aus |
| (D) Demagnetisieren | Aus | Aus | Y | Ein |
| (T) Tristate | Aus | Aus | Aus | Aus |

'Ein' bedeutet leitend, 'Aus' bedeutet nichtleitend. Das X in der Tabelle bedeutet 'Aus'; optional kann an dieser Stelle aber auch 'Ein' gewählt werden. Das Y in der Tabelle bedeutet 'Ein'; optional kann an dieser Stelle aber auch 'Aus' gewählt werden.

Während der Ladephase LP (Betriebszustand L oder H) wird mittels einer Gleichspannungsquelle 40 und des Ladezweigs LZ eine konstante Spannung U_{bb} an die elektrische Last 30 angelegt. Die Spannung U_{bb} führt zu einem Aufbau eines Stromes I_{L} durch die induktive Last 30, dessen Wert sich einem Maximalwert U_{bb}/(R_{L}| |R) asymptotisch nähert, der durch einen Gleichstromgesamtwiderstand R_{L}| |R der elektrischen Last 30 bestimmt wird. Die Genauigkeit des Einschaltens einer induktiven Last kann mittels Übererregung der induktiven Last 30 (Spule) durch Verwendung (Dimensionierung) einer Spule L mit geringerer Spulennennspannung erhöht werden. Wird beispielsweise eine Last 30 mit halber Nennspannung verwendet, also mit doppelter Nennspannung übererregt, dann wird sie fast doppelt so schnell aktiviert (wobei natürlich auch die mechanische Belastbarkeit des Bauelements, beispielsweise eines Magnetventils, nicht überfordert werden darf).

Während der Haltephase HP wird die konstante Spannung U_{bb} gepulst (beispielsweise mit einer Pulsdichtemodulation oder einer Pulsweitenmodulation) an die elektrische Last 30 angelegt (Betriebszustand L oder H). Damit der aufgebaute Strom I_{L} (siehe gestrichelte Linie in FIG 3) durch die elektrische Last 30 auch während der Pulspausen 65 weiterfließen kann, wird der Freilaufzweig FZ (zumindest) während der Pulspausen 65 (Betriebszustand F) leitend geschaltet.

Während jedes Pulses 64 erhöht sich der Strom I_{L} etwas. In jeder Pulspause 65 sinkt die Stromstärke I_{L} wegen des ohmschen Verbrauchs im Freilaufstromkreis FZ etwas ab. Mittels Einstellung eines Tastverhältnisses für die Pulse 64 kann eine Stärke I_{H} eines Haltestroms eingestellt werden, die gerade noch zuverlässig ausreicht, um die induktive Last 30 (beispielsweise die Spule L eines Magnetventils oder eines Relais) im eingeschalteten Zustand zu halten. Der Ausgangsstrom I_{L} wird auf ein pulsmodulationsgesteuertes Haltestromniveau I_{H} abgesenkt. Eine mittlere Haltespannung beträgt dann beispielsweise 75 % der Nennspannung der induktiven Last 30.

Durch den auf Haltestromniveau I_{H} abgesenkten Ausgangsstrom I_{L} kann ein Stromverbrauch und eine Verlustleistung während der Haltephase HP minimiert werden. Dies hat auch den Vorteil, dass die nachfolgende Demagnetisierungsphase DP insofern vorbereitet wird, als dass die Energie des Magnetfeldes der induktiven Last 30 verringert wird, welche in der nachfolgenden Demagnetisierungsphase DP zu löschen ist. Hierdurch ist ein schnelleres Löschen (Abschalten bzw. Inaktivschalten) einer elektromechanischen Last 30 möglich.

Um Spannungsspitzen und EMV-Probleme zu vermeiden, ist es bevorzugt, den Freilaufzweig FZ nicht nur während der Haltepulspausen 65, sondern auch während der Haltepulse 64 (also während der gesamten Haltephase HP durchgehend) leitend geschaltet zu lassen (mittels Abwechseln der Betriebszustände H und F). Unabhängig davon ist es im Interesse eines Rückspeiseschutzes und zur Verbesserung einer Busfähigkeit bevorzugt, wenn der Freilaufzweig FZ sonst immer, also nicht nur in der Tristate-Phase TP, sondern insbesondere auch während der Ladephase LP nichtleitend geschaltet ist.

Während der Demagnetisierungsphase DP ist von den drei Zweigen LZ, FZ, EZ kein Zweig (Betriebszustand D mit Y = 'Aus') oder nur der Entladezweig EZ (Betriebszustand D mit Y = 'Ein') leitend geschaltet. Wenn ein Strom I_{L}, der durch die induktive Last 30 fließt, mittels Nichtleitendschalten des Ladezweigs LZ unterbrochen wird, entsteht am Treiberausgang 27, 28 eine Spannung U_{L} mit umgekehrter Polung. Wenn die Versorgungsspannung U_{bb} beispielsweise 24 V beträgt und die Suppressordiode D4 beispielsweise eine Durchbruchspannung U_{Z} von 40 V aufweist, beträgt die Ausgangsspannung U_{L} zwischen den Abgriffen 25, 26 und der zweiten Versorgungsleitung minus 16 V. Aufgrund der umgekehrten Polung und aufgrund der Diode D3 im Entladezweig EZ kann dann auch kein Strom durch den Entladezweig EZ fließen. Den einzigen Weg, den der Strom I_{L} durch die induktive Last 30 zum Weiterfließen findet, verläuft über den Demagnetisierungszweig DZ, die Versorgungsleitungen 41, 42 und die Spannungsquelle 40. Dazu baut sich an der Suppressor- bzw. Zehnerdiode D4 eine Spannung auf, die etwas höher ist als die Durchbruchspannung U_{Z} der Suppressor- bzw. Zehnerdiode D4. Der Strom I_{L} fließt so lange über die Suppressor- bzw. Zehnerdiode D4 bis die gesamte Energie, die im Magnetfeld der elektrischen Last 30 enthalten ist, in der Suppressor- bzw. Zehnerdiode D4, in den Versorgungsleitungen 41, 42 (und - soweit vorhanden - auch in dem Innenwiderstand Ri der Spannungsquelle 40) in Wärme umgewandelt wurde. Durch Abbau der Magnetfeldenergie allein in der Suppressordiode kann die dabei entstehende Wärme (hinsichtlich Kühlung, Flächenanbindung) thermisch fokussiert und vorhersagbar abgeführt werden. Optional lässt sich durch Einstreuen von Zeiten mit dem Freilaufbetriebszustand F auch in der Demagnetisierungsphase DE ein gesteuertes Absinken des Stromflusses durch die induktive Last 30 erreichen.

Der in FIG 4 gezeigte zeitliche Verlauf einer Ausgangsspannung U_{L} umfasst eine Ladephase LP und eine Entladephase EP für eine kapazitive Last 30. Während der Ladephase LP wird mittels einer Gleichspannungsquelle 40 und des Ladezweigs LZ eine konstante Spannung U_{bb} an die elektrische Last 30 angelegt. Wenn die kapazitive Last 30 bei Anlegen der Spannung U_{bb} entladen ist, führt das Anlegen der Spannung U_{bb} direkt nach dem Anlegen zu einer Stromspitze 71, weil die entladene kapazitive Last 30 aus Sicht der Spannungsquelle 40 wie ein Kurzschluss wirkt. Die Höhe des Strom I_{L} durch die kapazitive Last 30 nähert sich nach der Einschaltstromspitze 71 einem Minimalwert Iₘᵢₙ asymptotisch, der durch einen Gleichstromwiderstand (ohmschen Gesamtwiderstand) der elektrischen Last 30 bestimmt wird.

Auch bei einer ohmisch-kapazitiven Last 30 kann eine (in der Figur nicht gezeigte) Haltephase mit Pulsmodulation sinnvoll sein, wenn für die ohmisch-kapazitive Last 30 ein Haltezustand erwünscht ist, in welchem eine Maximalspannung U_{bb} nicht dauerhaft angelegt werden soll. Eine Absenkung der Haltespannung mittels Pulsmodulation kann zu folgenden Zwecken genutzt werden:
- Minimierung einer Bauteilebelastung;
- Minimierung von Energieverlusten durch Leckströme;
- Anpassung der Treiberschaltung an Aktoren, deren Nennspannung niedriger ist als die Maximalspannung U_{bb};
- Verwendung unterschiedlicher Haltespannungen zur Übertragung von Telemetriedaten niedriger Baudrate mittels zwei oder mehr Spannungspegeln;
- Bereitstellung eines mittleren Spannungspegels (Betriebspunktes), der zur Aufmodulation von seriellen Daten (beispielsweise mittels eines Phasen- oder Quadraturmodulationsverfahrens) geeignet ist.

Während der Entladephase EP ist von den vier Zweigen LZ, FZ, DZ, EZ nur der Entladezweig EZ leitend geschaltet. Das Leitendschalten des Entladezweigs EZ führt direkt nach dem Leitendschalten zu einer Entladestromspitze 72, weil der leitend geschaltete Entladezweig EZ aus Sicht der geladenen kapazitiven Last 30 wie ein Kurzschluss wirkt. Die Höhe des Stroms I_{L} durch die kapazitive Last 30 nähert sich nach der Entladestromspitze 72 dem Nullwert 0 mA asymptotisch.

Mit der Schaltungstopologie der Schaltung 10 ist es also möglich, wahlweise folgende Aufgaben durchzuführen:
- hochgenaues Schalten von ohmschen Lasten 30 (in Ladephase LP und in Entladephase EP),
- hochgenaues Schalten von ohmsch-kapazitiven Lasten (Kabel) in Ladephase und Entladephase,
- hochgenaues Einschalten von induktiven Lasten 30 (in Ladephase LP),
- Halten von induktiven Lasten 30 (in Haltephase HP),
- hochgenaues Entmagnetisieren von induktiven Lasten 30 (in Demagnetisierungsphase DP).

Durch Kombination einer Gegentakttreiberstufe LZ, EZ (Q1, Q3) mit einem zuschaltbaren Freilaufzweig FZ (Q2) und einer Steuerung 29 lässt sich ein binärer Ausgang 27, 28 oder ein Tristate-Ausgang 27, 28 realisieren, mit dem wahlweise sowohl ohmsche, ohmsch-kapazitive wie auch induktive Lasten 30 (insbesondere elektromechanische Lasten) hochgenau angesteuert und energieeffizient im aktiven Zustand gehalten werden können. Die bisherige Notwendigkeit, für unterschiedliche Anwendungen unterschiedliche Treiberschaltungen bereitstellen zu müssen, wird vermieden.

Die Diode D1 verhindert ein unbeabsichtigtes Entladen über den Freilaufzweig FZ und die Bulk-Diode des zweiten Halbleiterschalters Q2. Die Diode D3 verhindert einen unbeabsichtigten Freilauf über den Entladezweig EZ und die Bulk-Diode des dritten Halbleiterschalters Q3, wenn eine induktive Last entmagnetisiert werden soll. Die Diode D4 verhindert einen unbeabsichtigte Rückspeisung über den Ladezweig LZ und die Bulk-Diode des ersten Halbleiterschalters Q3, wenn im Busbetrieb oder versehentlich eine Gegenspannungsquelle 31 an den Ausgang 27, 28 angeschlossen wird. Die Dioden D1, D2, D3 ermöglichen oder verbessern eine Tristate-Fähigkeit für einen Sperrbetrieb des Ausgangs 27, 28, weil sie Ströme in Durchflussrichtung der Bulk-Dioden der Halbleiterschalter Q1, Q2, Q3 unterbinden. Hierdurch ist die Treiberschaltung 20 gegenspannungsfest. Mittels Messung der Ausgangsspannung U_{L} an einem der Abgriffe 25, 26 oder am ersten Ausgang 27 kann die Treiberschaltung 20 auch in Verbindung mit einer Empfangsschaltung zum Empfangen von Daten und/oder Energie von einer Zentralstelle, von einer Gegenstelle oder von einem anderen Busteilnehmer verwendet werden und/oder auch zum Über.

## Patentansprüche

1. Treiberschaltung (20) mit einem Treiberausgang (27, 28) zum Betreiben einer elektrischen Last (30), wobei die Treiberschaltung (20) einen Ladezweig (LZ), der einen ersten steuerbaren Halbleiterschalter (Q1) aufweist, und einen Freilaufzweig (FZ) umfasst, der zu dem Treiberausgang (27, 28) parallel geschaltet ist, wobei der Freilaufzweig (FZ) eine Freilaufdiode (D2) und einen zweiten steuerbaren Halbleiterschalter (Q2) umfasst, der mit der Freilaufdiode (D2) in Serie geschaltet ist, **dadurch gekennzeichnet, dass** die Treiberschaltung (20) einen Entladezweig (EZ) umfasst, der einen dritten steuerbaren Halbleiterschalter (Q3) aufweist.

2. Treiberschaltung (20) nach Anspruch 1, **dadurch gekennzeichnet, dass** der Entladezweig (EZ) zu dem Freilaufzweig (FZ) parallel geschaltet ist.

3. Treiberschaltung (20) mit einem Treiberausgang (27,28) zum Betreiben einer elektrischen Last (30), wobei die Treiberschaltung (20) einen Ladezweig (LZ), der einen ersten steuerbaren Halbleiterschalter (Q1) aufweist, und einen Freilaufzweig (FZ) umfasst, der zu dem Treiberausgang (27, 28) parallel geschaltet ist, wobei der Freilaufzweig (FZ) eine Freilaufdiode (D2) und einen zweiten steuerbaren Halbleiterschalter (Q2) umfasst, der mit der Freilaufdiode (D2) in Serie geschaltet ist, **dadurch gekennzeichnet, dass** die Treiberschaltung (20) einen Demagnetisierungszweig (DZ) mit einem steuerbaren und/oder einem nicht steuerbaren Halbleiterschalter (D4) umfasst, der zu dem Ladezweig (LZ) oder zu dem Freilaufzweig (FZ) parallelgeschaltet ist.

4. Treiberschaltung (20) nach Anspruch 3, **dadurch gekennzeichnet, dass** der Halbleiterschalter (D4) des Demagnetisierungszweigs (DZ) eine Suppressordiode (24) oder eine Zenerdiode ist.

5. Treiberschaltung (20) nach Anspruch 3 oder 4, **da** - **durch gekennzeichnet**, dass die Treiberschaltung (20) einen Entladezweig (EZ) umfasst, der einen dritten steuerbaren Halbleiterschalter (Q3) aufweist.

6. Steuerung (29) für eine Treiberschaltung (20) nach einem der Ansprüche 1 bis 5, **dadurch gekennzeichnet, dass** die Steuerung (29) dazu vorbereitet ist, die Treiberschaltung (20) bedarfsabhängig in jedem der folgenden Betriebszustände zu betreiben:
- einem Ladebetriebszustand (L) und/oder einem Haltebetriebszustand (H), in welchem ein Ladezweig (LZ) der Treiberschaltung (20) leitend geschaltet ist, während ein Entladezweig (EZ) der Treiberschaltung (20) nichtleitend geschaltet ist;
- einem Freilaufbetriebszustand (F), in welchem ein Freilaufzweig (FZ) der Treiberschaltung (20) leitend geschaltet ist, während der Ladezweig (LZ) nichtleitend geschaltet ist;
- einem Entladebetriebszustand (E), in welchem der Entladezweig (EZ) leitend geschaltet ist, während der Ladezweig (LZ) und der Freilaufzweig (FZ) nichtleitend geschaltet sind.

7. Steuerung (29) für eine Treiberschaltung (20) nach einem der Ansprüche 1 bis 5, **dadurch gekennzeichnet, dass** die Steuerung (29) dazu vorbereitet ist, die Treiberschaltung (20) bedarfsabhängig in jedem der folgenden Betriebszustände zu betreiben:
- einem Ladebetriebszustand (L) und/oder einem Haltebetriebszustand (H), in welchem ein Ladezweig (LZ) der Treiberschaltung (20) leitend geschaltet ist, während ein Demagnetisierungszweig (DZ) der Treiberschaltung (20) nichtleitend geschaltet ist;
- einem Freilaufbetriebszustand (F), in welchem ein Freilaufzweig (FZ) der Treiberschaltung (20)leitend geschaltet ist, während der Ladezweig (LZ) nichtleitend geschaltet ist;
- einem Demagnetisierungsbetriebszustand (D), in welchem der Demagnetisierungszweig (DZ) leitend geschaltet ist, während der Ladezweig (LZ) und der Freilaufzweig (FZ) nichtleitend geschaltet sind.

8. Steuerung (29) nach Anspruch 7, **dadurch gekennzeichnet, dass** die Steuerung (29) auch dazu vorbereitet ist, die Treiberschaltung (20) bedarfsabhängig in einem Entladebetriebszustand (E) zu betreiben, in welchem der Entladezweig (EZ) leitend geschaltet ist, während der Ladezweig (LZ) und der Freilaufzweig (FZ) nichtleitend geschaltet sind.

9. Steuerung (29) nach einem der Ansprüche 6 bis 8, **da** - **durch gekennzeichnet**, dass die Steuerung (29) auch dazu vorbereitet ist, die Treiberschaltung (20) in einem Tristate-Betriebszustand (T) zu betreiben, in welchem der Ladezweig (LZ), der Freilaufzweig (FZ), der Entladezweig (EZ) und der Demagnetisierungszweig (DZ) nichtleitend geschaltet sind.

10. Treiberschaltung nach einem der Ansprüche 1 bis 5, **dadurch gekennzeichnet, dass** die Treiberschaltung (20) eine Steuerung nach einem der Ansprüche 6 bis 9 umfasst.
